# EUROPEAN PATENT APPLICATION

(11) **EP 4 492 441 A1**
(43) Date of publication of application: **15.01.2025**
(21) Application number: 23766400.8
(22) Date of filing: 08.02.2023
(51) Int. Cl.: H01L 21/673

(54) **WAFER CONTAINER AND WAFER SUPPORT**

(30) Priority: 08.03.2022 JP 2022035489
(71) Applicant: Murata Machinery, Ltd., Kyoto-shi, Kyoto 601-8326 (JP)
(72) Inventor: UENOYAMA Taito, Inuyama-shi, Aichi 484-8502 (JP); KATO Yumiko, Inuyama-shi, Aichi 484-8502 (JP); MIYASHITA Naoto, Inuyama-shi, Aichi 484-8502 (JP)
(74) Representative: Weickmann & Weickmann PartmbB
(86) International application number: PCT/JP2023/004239
(87) International publication number: WO 2023/171220

(57) **Abstract**

In a wafer container, cell rings constituting a container body each include an outer frame, a support part protruding inward from the outer frame, a first guide member and a second guide member provided inside the outer frame and disposed facing each other in a first direction, and a pair of third guide members provided inside the outer frame and disposed facing each other in a second direction. The container body includes a first flow path that guides inert gas upward, a horizontal flow path that guides the inert gas in a horizontal direction, and a second flow path that guides the inert gas downward. In the container body, the pair of third guide members prevents the inert gas in the horizontal flow path from deviating in the second direction.

## Description

### Technical Field

The present disclosure relates to a wafer container for storing a wafer and a wafer support serving as a component of the wafer container.

### Background Art

Wafer containers for storing wafers are conventionally known. International Publication No. 2014/107818 discloses a wafer container formed by stacking a plurality of wafer supports. A plurality of wafers are stored in the wafer container in a manner of facing each other in a vertical direction with a gap interposed therebetween. To maintain the cleanliness of the wafers, inert gas, such as nitrogen gas, is flowed into the inside of the wafer container. The inert gas flows through the gap between the wafers from one end of the wafer support (cell) to the other end.

### Citation List

### Patent Literature

[Patent Literature 1] International Publication No. 2014/107818

### Summary of Invention

### Technical Problem

In the conventional container, part of the inert gas tends to deviate through the gap between the wafers to the area of the periphery of the wafers on its way from one end of the cell to the other end. As a result, the concentration of the inert gas may possibly be insufficient, resulting in high oxygen concentration near the wafers.

The present disclosure describes a wafer container and a wafer support that can keep oxygen concentration near a wafer low.

### Solution to Problem

A wafer container according to an aspect of the present disclosure includes a container body formed by a plurality of wafer supports stacked in a vertical direction and configured to store a wafer, a top plate provided on an upper side of the container body, and a bottom plate provided on a lower side of the container body and having an inflow hole for inert gas. The wafer supports each include an outer frame forming a side surface of the container body, a support part protruding inward from the outer frame and configured to support the wafer, a first guide member and a second guide member provided inside the outer frame and disposed facing each other in a first direction orthogonal to the vertical direction, and a pair of third guide members provided inside the outer frame and disposed facing each other in a second direction orthogonal to both the vertical direction and the first direction. The container body includes a first flow path formed by the first guide member and configured to guide the inert gas from the inflow hole upward, a horizontal flow path configured to guide the inert gas from the first flow path in a horizontal direction, and a second flow path formed by the second guide member and configured to guide the inert gas from the horizontal flow path downward. In the container body, the pair of third guide members prevents the inert gas in the horizontal flow path from deviating in the second direction.

In the wafer container, the third guide members prevent the inert gas from deviating in the second direction when the inert gas flows through the horizontal flow path. Therefore, the concentration of the inert gas near the wafer is maintained. As a result, the oxygen concentration near the wafer can be kept low.

In two of the wafer supports stacked in the vertical direction, a first gap may be formed between the lower first guide member and the upper first guide member, and a second gap may be formed between the lower second guide member and the upper second guide member. The inert gas flows into the horizontal flow path through the first gap, and the inert gas flowing through the horizontal flow path deviates through the second gap. The restriction of deviation in the second direction by the third guide members and the first gap and the second gap create a flow toward the first direction and a flow that spreads over the entire area between the wafers.

In two of the wafer supports stacked in the vertical direction, a third gap may be formed between the lower third guide member and the upper third guide member. The third gap may be smaller than the first gap and smaller than the second gap. In this case, the inert gas that flows in through the first gap is less likely to flow out through the pair of third gaps positioned on both sides in the second direction and is more likely to flow out through the second gap. Therefore, a more suitable flow of the inert gas is created in the horizontal flow path.

The pair of third guide members may include a pair of inner peripheries extending along an outer periphery of the wafer supported by the support part when viewed from above. In this case, the inert gas can be reliably introduced to the outer periphery of the wafer, and deviation of the inert gas in the second direction can be reliably prevented.

The pair of third guide members may include a pair of inner peripheries extending along an outer periphery of the wafer supported by the support part when viewed from above. In the container body including the wafer supports stacked one another, an assembly of the pairs of inner peripheries may form a restriction wall configured to prevent the inert gas in the horizontal flow path from deviating in the second direction. In this case, the inert gas can be reliably introduced to the outer periphery of the wafer, and deviation of the inert gas in the second direction can be reliably prevented. The restriction wall formed in the container body guides or holds the inert gas only in the area for maintaining the cleanliness of the wafer.

A wafer support configured to support a wafer according to another aspect of the present disclosure includes an outer frame formed in a size to surround the wafer, a plurality of support parts protruding inward from the outer frame and configured to support the wafer, a first guide member and a second guide member provided inside the outer frame and disposed facing each other in a first direction orthogonal to a vertical direction, and a pair of third guide members provided inside the outer frame and disposed facing each other in a second direction orthogonal to both the vertical direction and the first direction. When the wafer supports are stacked, a first flow path is formed by a first frame member of the outer frame and the first guide member, and a second flow path is formed by a second frame member of the outer frame and the second guide member. The support parts are disposed between the first guide member and the pair of third guide members, and between the second guide member and the pair of third guide members.

A plurality of wafer supports can be prepared and stacked in the vertical direction to form the container body. The wafer is supported by the support parts. The third guide members can prevent the inert gas from deviating in the second direction. Therefore, the concentration of the inert gas near the wafer is maintained while the wafer is stored in the container body. As a result, the oxygen concentration near the wafer can be kept low.

The first guide member, the second guide member, and the pair of third guide members may be formed in a circular shape surrounding the outer periphery of the wafer supported by the support parts when viewed from above. In this case, the inert gas is guided or held only in the area for maintaining the cleanliness of the wafer in the container body composed of the stacked wafer supports.

### Advantageous Effects of Invention

According to some of the aspects of the present disclosure, the oxygen concentration near the wafer W can be kept low.

### Brief Description of Drawings

[FIG. 1] FIG. 1 is a schematic side view of a wafer storage system according to an embodiment of the present disclosure.
[FIG. 2] FIG. 2 is a schematic perspective view of a wafer container according to an embodiment of the present disclosure.
[FIG. 3] FIG. 3 is a perspective view of a container body in FIG. 2.
[FIG. 4] FIG. 4 is a perspective view of one wafer support in FIG. 3.
[FIG. 5] FIG. 5 is a plan view of the wafer support.
[FIG. 6] FIG. 6 is an enlarged plan view of an area near a third guide member in the wafer support.
[FIG. 7] FIG. 7 is an exploded perspective view of the container body, a top plate, and a bottom plate of the wafer container.
[FIG. 8] FIG. 8 is a view for explaining flow paths formed in the container body.
[FIG. 9] FIG. 9 is a sectional view of a first guide member and a second guide member.
[FIG. 10] FIG. 10 is a sectional view along line X-X of FIG. 2.
[FIG. 11] FIG. 11 is a sectional view of a pair of third guide members.
[FIG. 12] FIG. 12 is a diagram of the analysis results of oxygen concentration (distribution) in the wafer container according to the present disclosure.
[FIG. 13] FIG. 13 is a diagram of the analysis results of oxygen concentration (distribution) in a conventional wafer container.

### Description of Embodiments

Embodiments according to the present invention are described below with reference to the drawings. In the description of the drawings, like components are denoted by like reference numerals, and redundant explanation thereof is omitted.

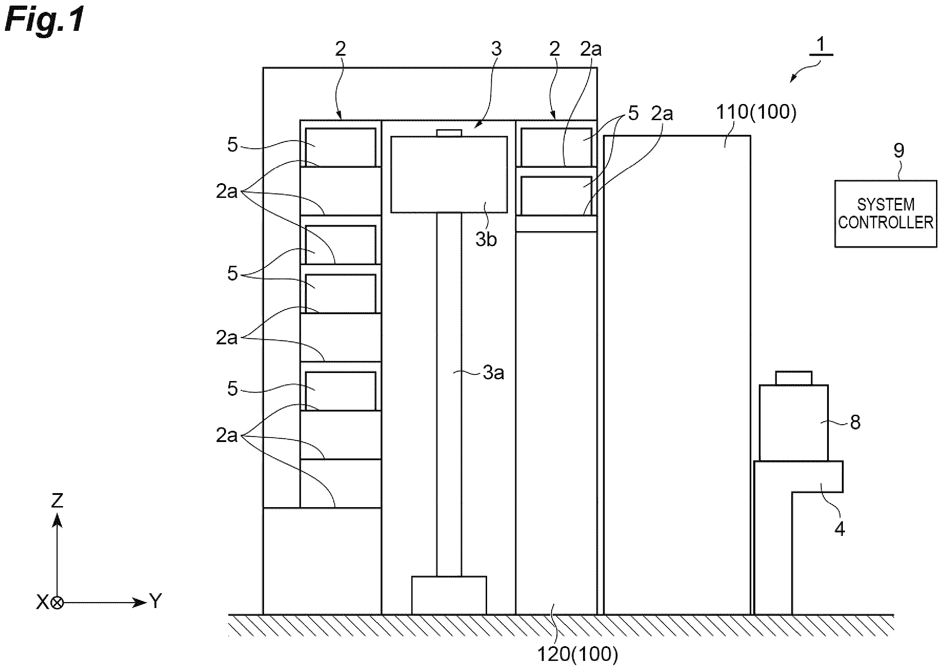

As illustrated in FIG. 1, a wafer storage system 1 includes a wafer transfer device 100, stockers 2, a crane 3, a port 4, and a system controller 9. In the following description, the term "top" corresponds to the upper side in the vertical direction, and the term "bottom" corresponds to the lower side in the vertical direction. An X-direction is one horizontal direction, a Y-direction is another horizontal direction orthogonal to the X-direction, and a Z-direction is the up-down (vertical) direction.

The stocker 2 is a device that stores wafer containers 5. The stocker 2 has a plurality of shelves 2a arrayed in the X- and Z-directions and on which the wafer containers 5 are placed. A plurality of (two in the present description) stockers 2 are provided facing each other in the Y-direction, for example. In the example illustrated in the figure, one of the stockers 2 is provided on a ring opener 120 of the wafer transfer device 100, for example. The crane 3 is a transport device that transports the wafer container 5. The crane 3 transfers the wafer container 5 between the shelf 2a and the ring opener 120. The crane 3 is disposed in the area between the stockers 2 facing each other. The crane 3 moves on a traveling rail (not illustrated) disposed along the X-direction on the floor. The crane 3 includes a guide rail 3a extending in the Z-direction and a hoisting frame 3b that can elevate along the guide rail 3a.

The wafer transfer device 100 transfers a disc-shaped wafer serving as material for a semiconductor element to the wafer container 5. The wafer transfer device 100 includes a wafer handling robot 110 and the ring opener 120. The port 4 is a part where a front opening unified pod (FOUP) 8 is transferred between a transport vehicle or an operator and the wafer storage system 1. The transport vehicle travels along a track provided on the ceiling of a semiconductor plant and transports the FOUP 8. The transport vehicle is an overhead automatic guided vehicle to which the FOUP 8 can be transferred. The transport vehicle is also referred to as, for example, a cart (transport cart), an overhead traveling vehicle (overhead transport vehicle), or a traveling vehicle. The FOUP 8 brought by the operator can be carried in the wafer storage system 1, and the FOUP 8 carried out of the wafer storage system 1 can be received by the operator. The FOUP 8 is placed on the port 4 by being transported by the transport vehicle or the operator. The FOUP 8 has a box-shaped housing with an opening and a lid covering the opening. The lid is detachably provided to the housing. The FOUP 8 accommodates one or a plurality of wafers.

The system controller 9 that controls the operations of the wafer storage system 1 is an electronic control unit composed of a central processing unit (CPU), a read only memory (ROM), a random access memory (RAM), and other components. The system controller 9 may be implemented by, for example, software control of loading a computer program stored in the ROM on the RAM and executing it by the CPU or hardware control of combining electronic circuits and the like. The system controller 9 may be a single device, or a plurality of devices may be connected via a communication network, such as the Internet or an intranet, to logically construct a single system controller 9.

In the wafer storage system 1, transferring the wafers from the wafer container 5 stored in the stocker 2 to the FOUP 8 is performed. For example, an empty FOUP 8 is placed on the port 4 by the transport vehicle or the operator. The crane 3 moves the wafer container 5 from the shelf 2a of the stocker 2 to the ring opener 120. The ring opener 120 opens the wafer container 5 to allow the wafers to be taken out of the wafer container 5 and opens the lid of the FOUP 8. The wafer handling robot 110 takes out a wafer from the wafer container 5 and stores the wafer in the FOUP 8. After a predetermined number of wafers are stored in the FOUP 8, the lid of the FOUP 8 is closed. Thus, the transfer of the wafers from the wafer container 5 to the FOUP 8 is completed. The transfer of the wafers from the FOUP 8 to the wafer container 5 can be achieved by carrying out the processing described above in reverse order. The wafer storage system 1 can automatically perform the transfer of the wafers from the wafer container 5 and the FOUP 8.

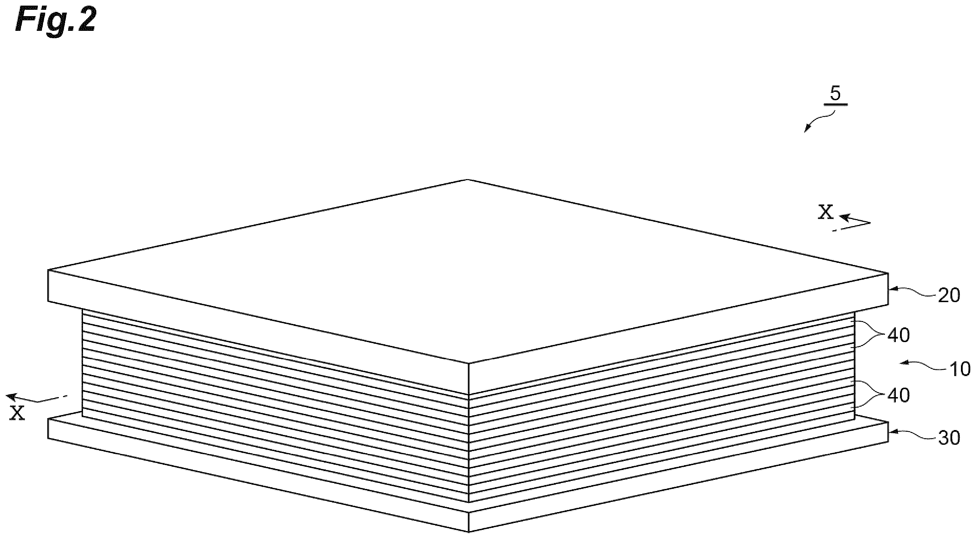

The wafer container 5 is a container used by the wafer transfer device 100 to transfer the wafers. As illustrated in FIGS. 2 to 5, the wafer container 5 includes a plurality of cell rings (wafer supports) 40 for holding (supporting) wafers W. The cell ring 40 is a molded resin component, for example. The wafer W has a disc shape, for example. The wafer W does not necessarily have a disc shape. The wafer W may have a shape in which part of the disc is cut out (e.g., a flat-shaped cutout formed by cutting out the disc along a straight line corresponding to a chord or a notch-shaped cutout formed by cutting out part of the periphery in a triangular shape). The wafer W has at least an arc part. The center of the wafer W is defined with respect to the arc part.

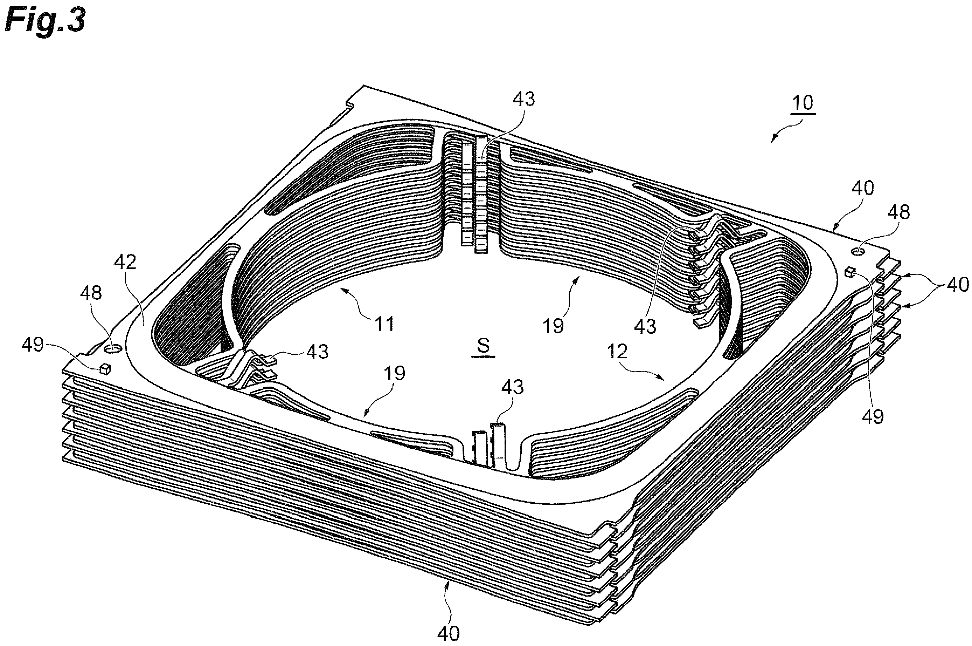

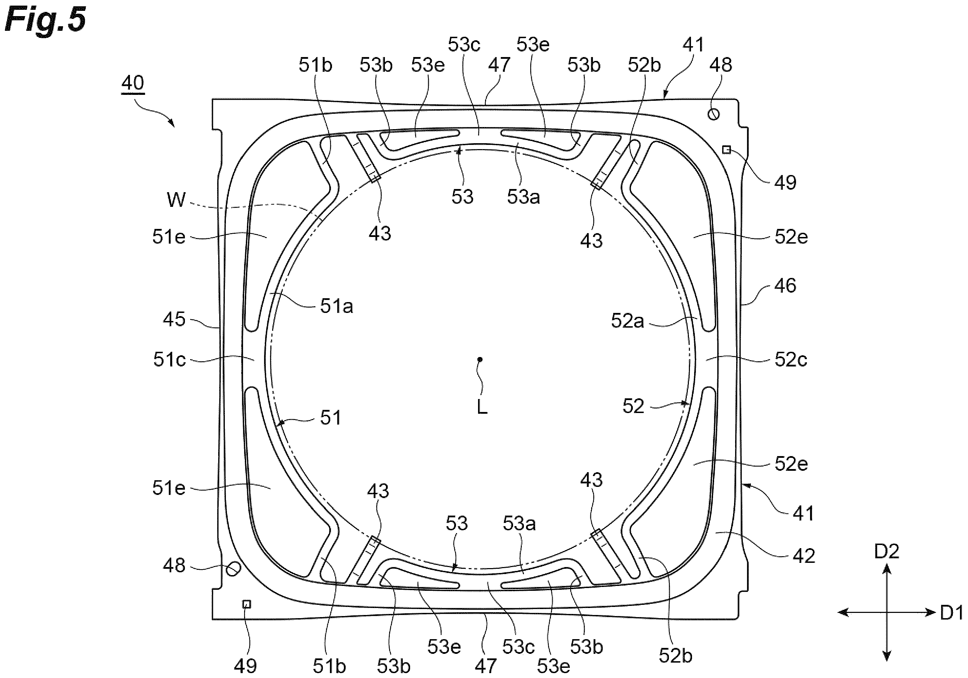

Each cell ring 40 has holes 48 and protrusions 49, for example, at the corners (refer to FIG. 5). On one cell ring 40, another cell ring 40 is stacked in a manner of being rotated 180 degrees with respect to the one cell ring 40. The protrusions 49 of one cell ring 40 are inserted into the holes 48 of another cell ring 40, whereby the plurality of cell rings 40 are positioned. As illustrated in FIG. 3, the cell rings 40 have the same external shape and are perfectly stacked in the vertical direction. The cell rings 40 constitute a container body 10 for storing the wafers W. The multilayered structure of the cell rings 40 and the mechanism for opening and closing the wafer container 5 by the ring opener 120 can be implemented by known structures, mechanisms, and/or methods as disclosed in International Publication No. 2021/044791, for example.

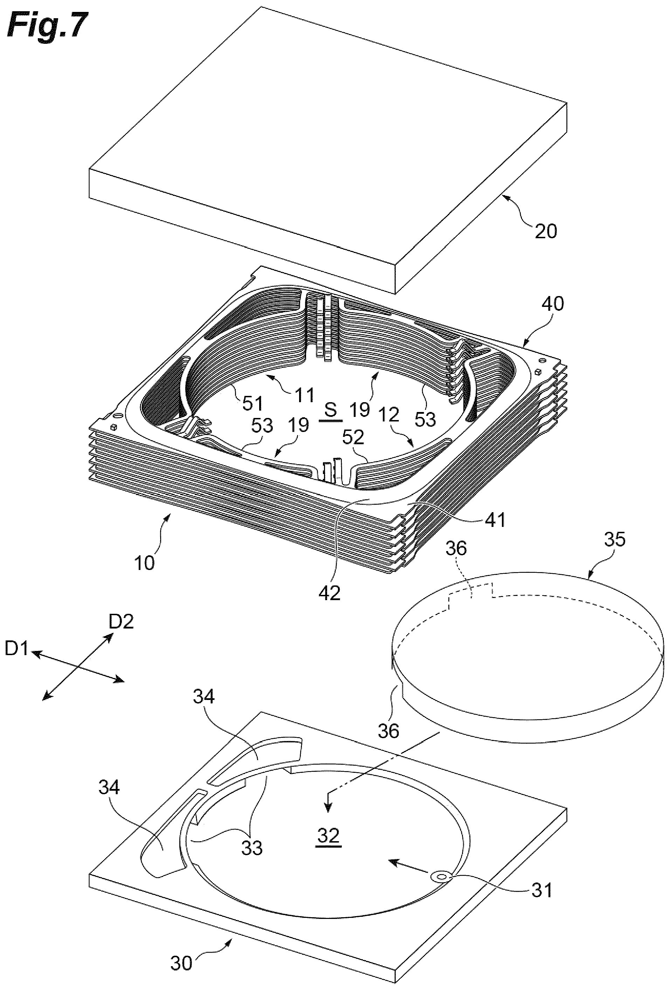

As illustrated in FIGS. 2 and 7, the wafer container 5 includes a plurality of cell rings 40, a top plate 20, and a bottom plate 30. The cell rings 40 are stacked in the vertical direction with almost no gap interposed therebetween to serve as a multilayered structure. The top plate 20 is provided on the upper side of the multilayered structure of the cell rings 40. The bottom plate 30 is provided on the lower side of the multilayered structure of the cell rings 40. The "vertical direction" and the "stacking direction" have the same meaning. The cell rings 40 constitute the container body 10 for storing the wafers W. The cell rings 40 are stacked with their outer frames 41 adjacent in the vertical direction being in contact with each other so as to make the container body 10 as airtight as possible. More specifically, the outer frame 41 includes a protruding frame part 42 with a rounded rectangular shape slightly smaller than the outer periphery of the outer frame 41. In the outer frames 41 adjacent to each other in the vertical direction, the inner ends in the radial direction of the protruding frame parts 42 are in contact with each other. The top plate 20 and the bottom plate 30 are plate-shaped members, for example. The bottom plate 30 is placed on the shelf 2a of the stocker 2. The stacked cell rings 40 are pressed downward by the weight of the top plate 20, for example. The wafer container 5 is placed in a horizontal position on the shelf 2a, for example. A first direction D1 and a second direction D2 are defined with respect to the wafer container 5 (which will be described later in detail). For example, the first direction D1 may correspond to the Y-direction, and the second direction D2 may correspond to the X-direction. Alternatively, the first direction D1 may correspond to the X-direction, and the second direction D2 may correspond to the Y-direction. The wafer container 5 is placed on the shelf 2a such that a nozzle disposed on the shelf 2a matches the position of an inflow hole 31 of the wafer container 5. There are variations in the arrangement of the nozzle, and the orientation of the wafer container 5 can change accordingly.

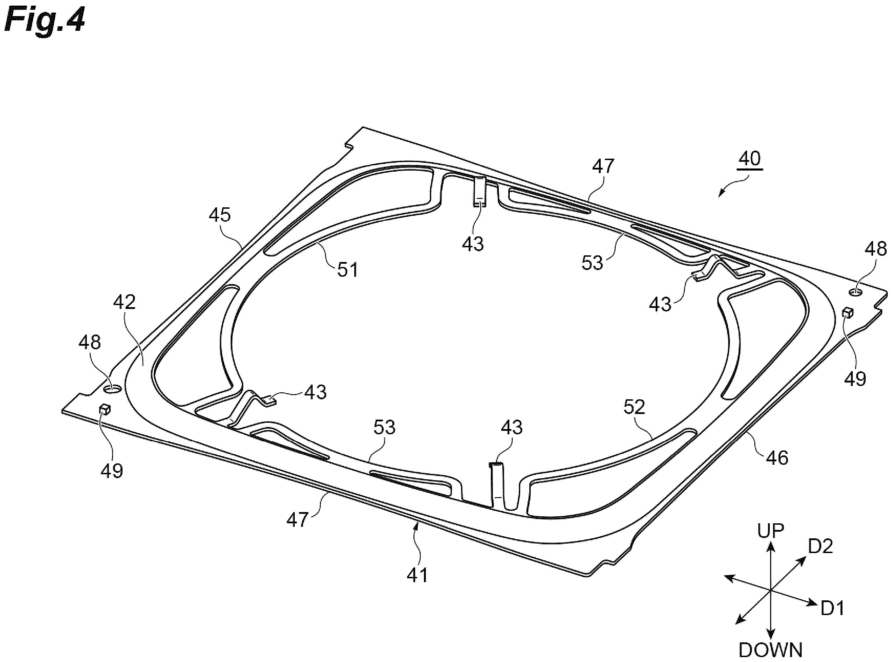

Next, the structure of the cell ring 40 is described in detail with reference to FIGS. 4 and 5. As illustrated in FIGS. 4 and 5, each cell ring 40 has a rectangular outer frame 41. The outer frame 41 has a rectangular or square shape, for example. The wafer W is placed and supported in the outer frame 41. In the present specification, a central axis L passing through the center of the wafer W supported by the outer frame 41 is defined. The central axis L passes through the center of the wafer W and is orthogonal to the wafer W. In the wafer container 5, the direction of the central axis L corresponds to the Z-direction, that is, the vertical direction. The outer frame 41 includes a first frame member 45, a second frame member 46, and a pair of third frame members 47. The first frame member 45 and the second frame member 46 are spaced apart in the first direction D1 orthogonal to the central axis L and are disposed at both ends in the first direction D1. The pair of third frame members 47 are spaced apart in the second direction D2 orthogonal to both the central axis L and the first direction D1 and are disposed at both ends in the second direction D2. The rectangular outer frame 41 is composed of the first frame member 45 and the second frame member 46 extending in parallel and the pair of third frame members 47 extending in parallel. When a plurality of cell rings 40 are stacked to form the container body 10, the outer frames 41 serve as the four side surfaces of the container body 10.

Each cell ring 40 includes a plurality of (e.g., four) support parts 43 that protrude inward from the outer frame 41 and support the wafer W. The support part 43, for example, protrudes above the outer frame 41 and holds the wafer W above the outer frame 41. The support parts 43 are disposed such that they are positioned on a virtual circumference equal to the diameter of the wafer W. The wafer W is placed on the horizontal end pieces of the support parts 43. The cell rings 40 may be designed such that the positions of the support parts 43 and 43 provided at a certain part in the circumferential direction are slightly different in the circumferential direction in two cell rings 40 adjacent to each other in the vertical direction (refer to FIG. 3).

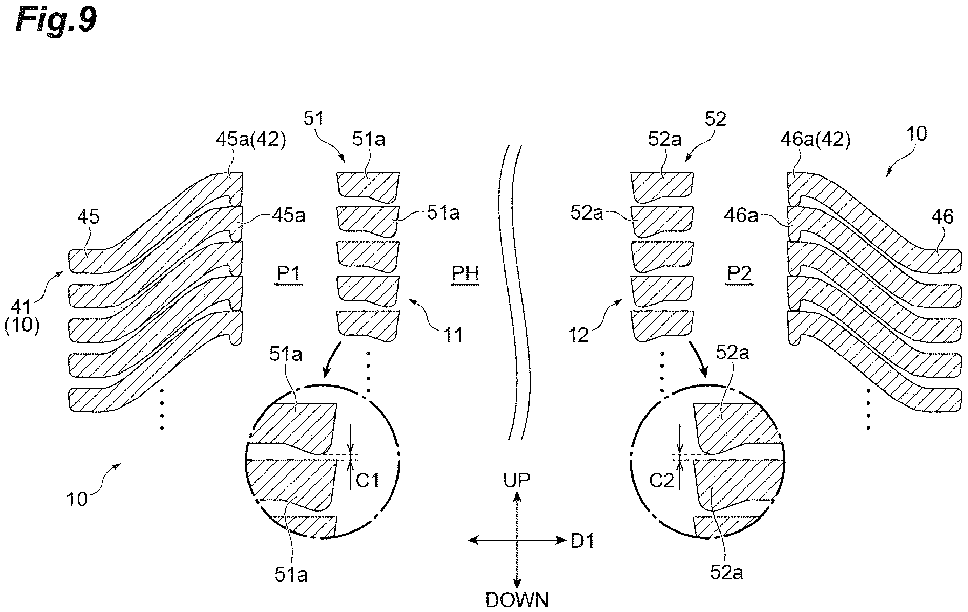

Each cell ring 40 includes a first guide member 51 and a second guide member 52 provided inside the outer frame 41 and disposed facing each other in the first direction D1. The first guide member 51 is provided in the area corresponding to the first frame member 45 and the ends of the pair of third frame members 47 (corners closer to the first frame member 45) and protrudes toward the inner side of the outer frame 41. The second guide member 52 is provided in the area corresponding to the second frame member 46 and the ends of the pair of third frame members 47 (corners closer to the second frame member 46) and protrudes toward the inner side of the outer frame 41. The first frame member 45 and the second frame member 46 may be formed to slightly protrude upward toward the inner side with respect to the outermost periphery of the outer frame 41, for example (also refer to FIG. 9). The first guide member 51 and the second guide member 52 may horizontally extend at substantially the same height as the first frame member 45 and the second frame member 46.

The first guide member 51 and the second guide member 52 may be line-symmetrical with respect to the central axis L. The first guide member 51 and the second guide member 52 may be plane-symmetrical with respect to a plane containing the central axis L and parallel to the second direction D2. The cell rings 40 are stacked in a manner of being rotated 180 degrees as described above. Because of the symmetry of the outer frame 41, the cell ring 40 illustrated in FIG. 5 and the cell ring 40 rotated 180 degrees around the central axis L have substantially the same shape. However, in the cell rings 40 adjacent to each other in the vertical direction, the shapes of the outer peripheries do not completely overlap. The position of the protrusion 49 of the lower cell ring 40 matches the position of the hole 48 of the upper cell ring 40. In the present specification, the guide member positioned on the side of a first flow path P1 (which will be described later) of the container body 10 is referred to as the first guide member 51, and the guide member positioned on the side of a second flow path P2 of the container body 10 is referred to as the second guide member 52 regardless of the orientation of the cell ring 40.

The first guide member 51 includes a first arc-shaped part 51a, a pair of first end support parts 51b, and a first center support part 51c. The first arc-shaped part 51a extends along the outer periphery of the wafer W supported by the support parts 43. The pair of first end support parts 51b extends toward the inner side of the outer frame 41 from the corners between the first frame member 45 and the pair of third frame members 47 and supports both ends of the first arc-shaped part 51a. The first center support part 51c is provided to the center part of the first frame member 45 and supports the center part of the first arc-shaped part 51a. The area in which the first arc-shaped part 51a is provided may be 90 degrees or larger as a central angle around the central axis L.

The second guide member 52 includes a second arc-shaped part 52a, a pair of second end support parts 52b, and a second center support part 52c. The second arc-shaped part 52a extends along the outer periphery of the wafer W supported by the support parts 43. The pair of second end support parts 52b extends toward the inner side of the outer frame 41 from the corners between the second frame member 46 and the pair of third frame members 47 and supports both ends of the second arc-shaped part 52a. The second center support part 52c is provided to the center part of the second frame member 46 and supports the center part of the second arc-shaped part 52a. The area in which the second center support part 52c is provided may be 90 degrees or larger as a central angle around the central axis L.

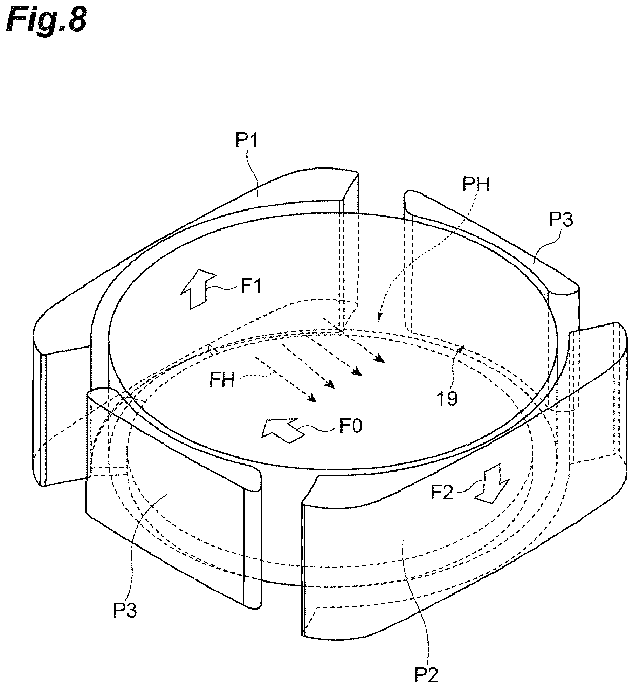

The first guide member 51 and the second guide member 52 form flow paths for the inert gas in the container body 10. The configuration of the flow paths of the container body 10 is described in greater detail with reference to FIGS. 7 and 8. As illustrated in FIG. 7, the bottom plate 30 has the inflow hole 31 passing through the bottom plate 30 in the vertical direction. The inflow hole 31 is positioned near the second frame member 46 of the outer frame 41 in plan view. The top surface (inner surface facing the inside of the container body 10) of the bottom plate 30 has a circular introduction flow path recess 32 that allows the inert gas to flow through. The bottom plate 30 is provided with a circular resin chamber 35 that covers the introduction flow path recess 32. Two openings 36 are formed at parts of the cylindrical part extending downward from the disc part. The bottom plate 30 has two openings 33 and two gas introduction spaces 34 at positions corresponding to the two openings 36. An introduction flow F0 (refer to FIG. 8) of the inert gas is guided through the openings 36, the openings 33, and the gas introduction spaces 34 to the first flow path P1 and becomes an upward flow F1. The configuration of the bottom plate 30 is not particularly limited to the configuration described above. The bottom plate 30 introduces the inert gas through the inflow hole 31 from an external pipe or the like and causes the inert gas to flow into the introduction flow path recess 32. In the container body 10, the first guide member 51 is positioned opposite to the inflow hole 31 in the first direction D1. FIG. 8 illustrates the inert gas introduction flow F0 flowing in a horizontal direction in the introduction flow path recess 32.

When a plurality of cell rings 40 are stacked to form the container body 10, the first flow path P1 is formed by the first guide member 51 and the first frame member 45 (also refer to FIG. 9). The first flow path P1 can be considered to be a space formed by a plurality of first openings 51e between the first frame member 45 and the first guide member 51. The first flow path P1 guides the inert gas from the inflow hole 31 upward. In a housing space S (refer to FIG. 3) of the container body 10, a horizontal flow path PH is formed between two wafers W supported by any two cell rings 40. The horizontal flow path PH guides the inert gas from the first flow path P1 in a horizontal direction. When a plurality of cell rings 40 are stacked to form the container body 10, the second flow path P2 is formed by the second guide member 52 and the second frame member 46 (also refer to FIG. 9). The second flow path P2 can be considered to be a space formed by a plurality of second openings 52e between the second frame member 46 and the second guide member 52. The second flow path P2 guides the inert gas from the horizontal flow path PH downward. FIG. 8 illustrates the upward flow F1 of the inert gas flowing upward in the first flow path P1, a horizontal flow FH of the inert gas flowing in a horizontal direction in the horizontal flow path PH, and a downward flow F2 of the inert gas flowing downward in the second flow path P2.

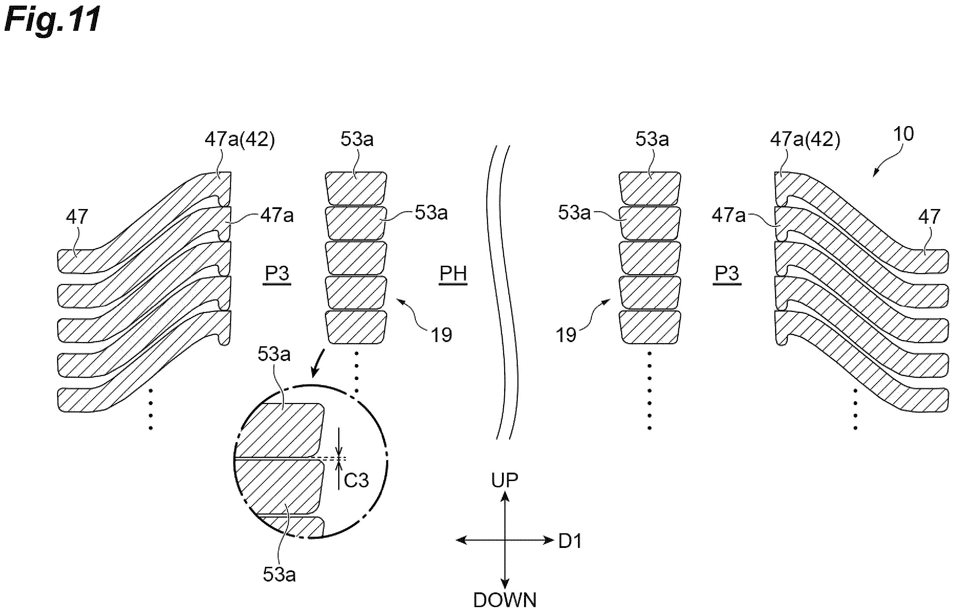

The structure (gap) that communicates between the first flow path P1 and the horizontal flow path PH is formed by the first guide members 51 adjacent to each other in the vertical direction. The structure (gap) that communicates between the horizontal flow path PH and the second flow path P2 is formed by the second guide members 52 adjacent to each other in the vertical direction. These communication structures are described with reference to FIG. 9. FIG. 9 is a sectional view of the first frame members 45, the second frame members 46, the first guide members 51, and the second guide members 52. As illustrated in FIG. 9, in two cell rings 40 stacked in the vertical direction, a first gap C1 in the vertical direction is formed between the lower first guide member 51 and the upper first guide member 51. In other words, the first gap C1 is formed between the first arc-shaped parts 51a (first inner peripheries) adjacently disposed in the vertical direction. A second gap C2 in the vertical direction is formed between the lower second guide member 52 and the upper second guide member 52. In other words, the second gap C2 is formed between the second arc-shaped parts 52a (first inner peripheries) adjacently disposed in the vertical direction. The second gap C2 is equal to the first gap C1, for example. In the container body 10, first frame inner ends 45a of the two adjacent first frame members 45, second frame inner ends 46a of the two adjacent second frame members 46, and third frame inner ends 47a (refer to FIG. 11) of the two adjacent third frame members 47 are linearly in contact with each other (linear contact) in the vertical direction. Thus, airtightness (sealability) in the container body 10 is secured to some extent. The first frame inner end 45a, the second frame inner end 46a, and the third frame inner end 47a are part of the protruding frame part 42 with a rectangular frame shape. By contrast, the first gaps C1 and the second gaps C2 are formed between the first guide members 51 and between the second guide members 52, respectively.

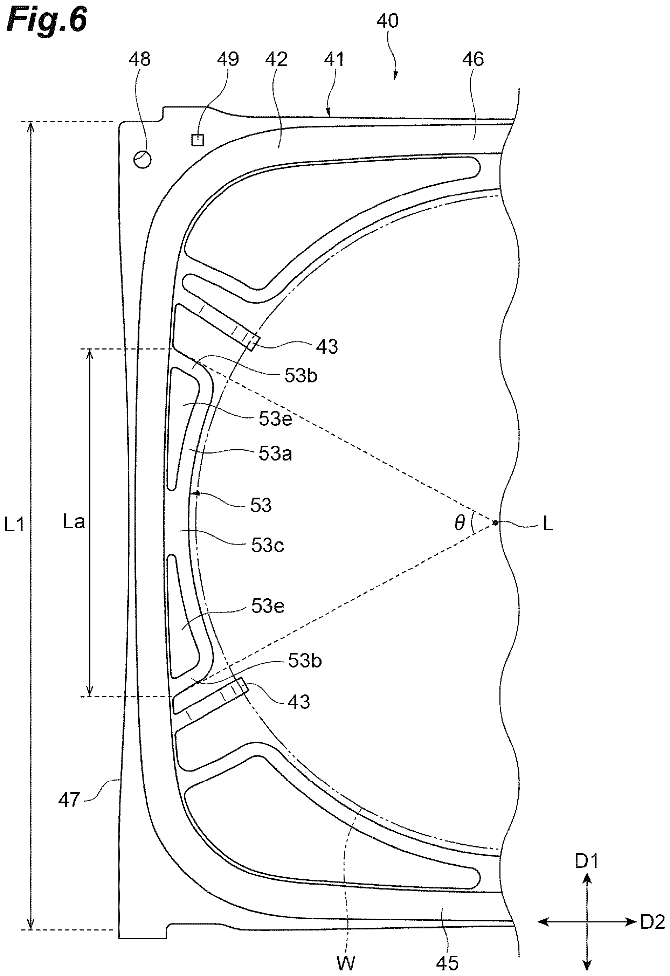

Next, a measure for preventing rise in oxygen concentration equipped with the wafer container 5 is described with reference to FIGS. 4 to 8, 10, and 11. As illustrated in FIGS. 4 and 5, each cell ring 40 includes a pair of third guide members 53 provided inside the outer frame 41 and disposed facing each other in the second direction D2. As illustrated in FIGS. 5 and 6, the third guide member 53 is provided to an area corresponding only to a part including the center part on the third frame member 47 and protrudes toward the inner side of the outer frame 41. The third frame member 47 may be formed to slightly protrude upward toward the inner side with respect to the outermost periphery of the outer frame 41, for example (also refer to FIG. 11). The third guide member 53 may horizontally extend at substantially the same height as the third frame member 47.

The pair of third guide members 53 may be line-symmetrical with respect to the central axis L. The pair of third guide members 53 may be plane-symmetrical with respect to a plane containing the central axis L and parallel to the first direction D1.

Each third guide member 53 includes a third arc-shaped part 53a, a pair of third end support parts 53b, and a third center support part 53c. The third arc-shaped part 53a extends along the outer periphery of the wafer W supported by the support parts 43. The pair of third end support parts 53b extends toward the inner side of the outer frame 41 from the third frame member 47 and supports both ends of the third arc-shaped part 53a. The third center support part 53c is provided to the center part of the third frame member 47 and supports the center part of the third arc-shaped part 53a.

The third guide member 53 includes the third arc-shaped part 53a (third inner periphery) extending along the outer periphery of the wafer W supported by the support parts 43 when viewed from the direction of the central axis L. The support parts 43 are disposed between the first guide member 51 and the second guide member 52 described above and the pair of third guide members 53. The first guide member 51, the second guide member 52, and the pair of third guide members 53 are formed in a circular shape surrounding the outer periphery of the wafer W supported by the support parts 43 when viewed from the direction of the central axis L. More specifically, the first arc-shaped part 51a, the second arc-shaped part 52a, and the pair of third arc-shaped parts 53a are formed in a circular shape surrounding the outer periphery of the wafer W supported by the support parts 43 when viewed from the direction of the central axis L. In the present specification, the term "viewed from the direction of the central axis L" has the same meaning as "viewed from above (in the vertical direction)".

As illustrated in FIG. 6, the area in which the third guide member 53 is provided is an angle θ as a central angle around the central axis L. The angle θ may be 60 degrees or smaller or 45 degrees or smaller, for example. The range of the angle θ may be determined by considering the arrangement of the support parts 43. The third guide member 53 is disposed at a position avoiding a pair of support parts 43 provided to one third frame member 47. In terms of the length in the first direction D1, the area in which the third guide member 53 is provided is only a length La, which is part of the total length L1 of the outer frame 41 in the first direction D1. The ratio of the length La to the length L1 may be 60% or smaller or 50% (half) or smaller.

As illustrated in FIGS. 7, 8, and 10, when a plurality of cell rings 40 are stacked to form the container body 10, a pair of flow restriction spaces P3 is formed by the pair of third guide members 53. The flow restriction space P3 can be considered to be a space formed by a plurality of third openings 53e between the third frame member 47 and the third guide member 53. As illustrated in FIG. 11, in two cell ring 40 stacked in the vertical direction, a third gap C3 in the vertical direction is formed between the lower third guide member 53 and the upper third guide member 53. The third gap C3 is formed to secure contact between the outer frames 41 in the protruding frame parts 42 (specifically, contact between the first frame inner ends 45a, between the second frame inner ends 46a, and between the third frame inner ends 47a) and prevent the outer frames 41 from lifting. In other words, the third gap C3 is formed between the third arc-shaped parts 53a (third inner peripheries) adjacently disposed in the vertical direction. The third gap C3 is smaller than the first gap C1 in the first guide member 51 and smaller than the second gap C2 in the second guide member 52. The ratio of the third gap C3 to the first gap C1 may be 50% (half) or smaller. The ratio of the third gap C3 to the second gap C2 may be 50% (half) or smaller. Therefore, the inert gas flowing through the horizontal flow path PH is less likely to enter the third gap C3. In the container body 10, the assembly of the third arc-shaped parts 53a forms a restriction wall 19 that restricts deviation in the second direction D2 of the inert gas in the horizontal flow path PH. By contrast, the assembly of the first arc-shaped parts 51a forms an inflow wall 11 that allows the inert gas to flow into the horizontal flow path PH. The assembly of the second arc-shaped parts 52a forms an outflow wall 12 that allows the inert gas to flow out of the horizontal flow path PH.

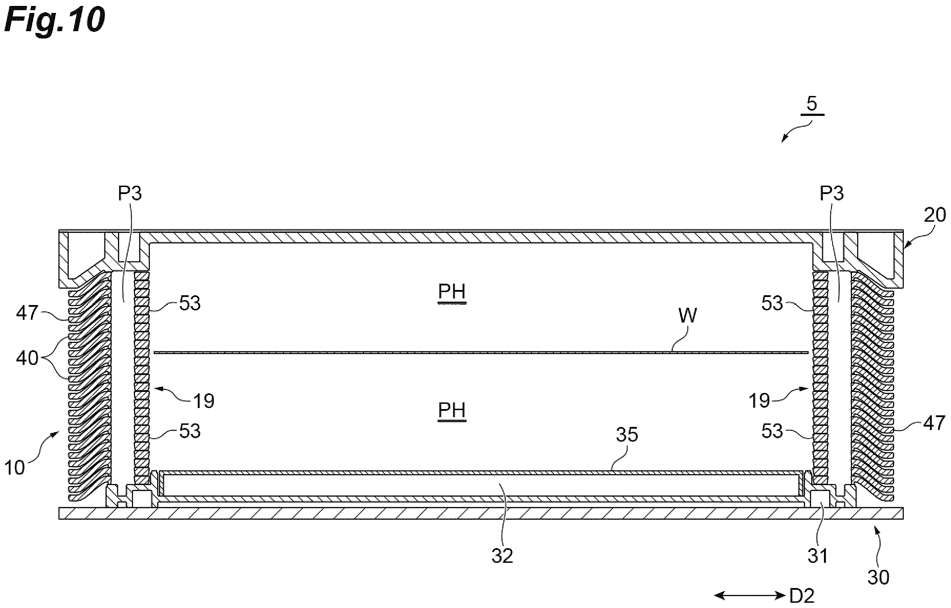

As described above, in the container body 10 of the wafer container 5, the pair of third guide members 53 prevents the inert gas in the horizontal flow path PH from deviating in the second direction D2. In the wafer container 5 illustrated in FIG. 10, the inert gas flowing through the horizontal flow path PH is more likely to flow in the vertical direction on the paper surface or the direction across the paper surface, but deviation of the inert gas to the left and right direction in the figure (deviation to the flow restriction space P3) is less likely to occur.

In the wafer container 5 according to the present embodiment, the third guide members 53 prevent the inert gas from deviating in the second direction D2 when the inert gas flows through the horizontal flow path PH. Therefore, the concentration of the inert gas near the wafer W is maintained. As a result, the oxygen concentration near the wafer W can be kept low.

In the wafer container 5, the inert gas flows into the horizontal flow path PH through the first gap C1, and the inert gas flowing through the horizontal flow path PH flows out through the second gap C2. The restriction of deviation in the second direction D2 by the third guide members 53 and the first gap C1 and the second gap C2 create a flow toward the first direction D1 and a flow that spreads over the entire area between the wafers W.

The third gap C3 between the third guide members 53 is smaller than the first gap C1 and smaller than the second gap C2. The inert gas that flows in through the first gap C1 is less likely to deviate through the pair of third gaps C3 positioned on both sides in the second direction D2 and is more likely to flow out through the second gap C2. Therefore, a more suitable flow of the inert gas is created in the horizontal flow path PH.

The pair of third guide members 53 includes a pair of third arc-shaped parts 53a extending along the outer periphery of the wafer W when viewed from the direction of the central axis L. Therefore, the inert gas can be reliably introduced to the outer periphery of the wafer W, and deviation of the inert gas in the second direction D2 can be reliably prevented.

The assembly of the pairs of third arc-shaped parts 53a forms the restriction wall 19 that restricts deviation in the second direction D2 of the inert gas in the horizontal flow path PH. Therefore, the inert gas can be reliably introduced to the outer periphery of the wafer W, and deviation of the inert gas in the second direction D2 can be reliably prevented. The restriction wall 19 formed in the container body 10 guides or holds the inert gas only in the area for maintaining the cleanliness of the wafer W.

A plurality of cell rings 40 according to the present embodiment are prepared and stacked in the vertical direction to form the container body 10. The wafer W is supported by the support parts 43. The third guide members 53 can prevent the inert gas from deviating in the second direction D2. Therefore, the concentration of the inert gas near the wafer W is maintained while the wafer W is stored in the container body 10. As a result, the oxygen concentration near the wafer W can be kept low.

The first guide member 51, the second guide member 52, and the pair of third guide members 53 are formed in a circular shape surrounding the outer periphery of the wafer W when viewed from the direction of the central axis line L. Therefore, the inert gas is guided or held only in the area for maintaining the cleanliness of the wafer W in the container body 10 composed of the stacked cell rings 40.

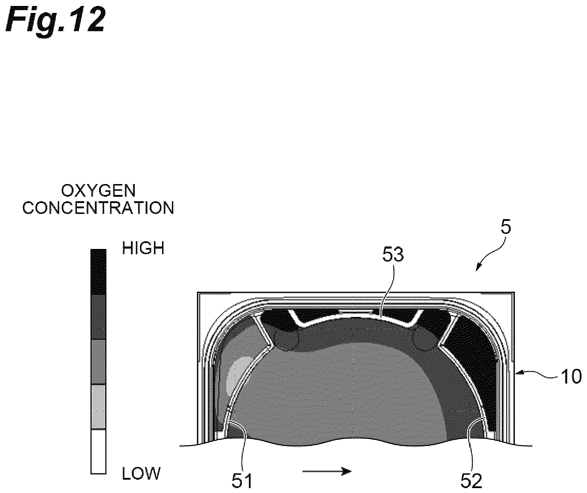

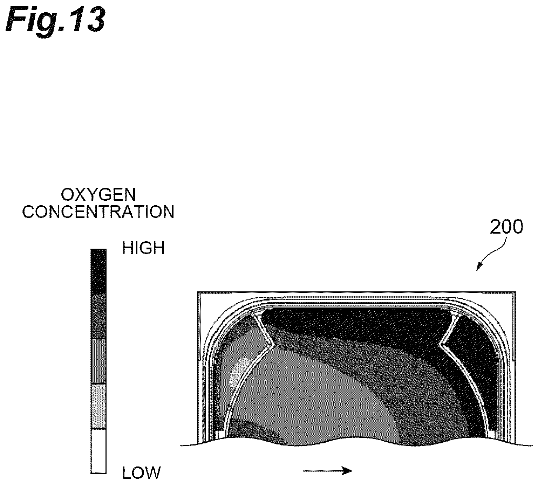

FIG. 12 is a diagram of the analysis results of oxygen concentration (distribution) in the wafer container 5 according to the present disclosure. FIG. 13 is a diagram of the analysis results of oxygen concentration (distribution) in a conventional wafer container 200. In this analysis, simulations of flowing inert gas into both containers were performed in an atmosphere where oxygen was present. As illustrated in FIGS. 12 and 13, the low oxygen concentration area is expanded by providing the third guide member 53 in the wafer container 5. By contrast, the wafer container 200 without the third guide member 53 has a narrower low oxygen concentration area. This seems to be caused by the deviation (diffusion) of the inert gas in the second direction D2.

While the embodiment according to the present disclosure has been described above, the present invention is not limited to the embodiment described above. For example, the shapes and sizes of the first guide member 51, the second guide member 52, and the third guide member 53 can be appropriately changed. The position or the like of the inflow hole 31 in the bottom plate 30 can also be changed. The number of cell rings 40 to be stacked is not particularly limited.

### Reference Signs List

- 5: wafer container
- 10: container body
- 11: inflow wall
- 12: outflow wall
- 19: restriction wall
- 20: top plate
- 30: bottom plate
- 31: inflow hole
- 40: cell ring (wafer support)
- 41: outer frame
- 43: support part
- 45: first frame member
- 46: second frame member
- 47: third frame member
- 51: first guide member
- 52: second guide member
- 53: third guide member
- 53A: third arc-shaped part (third inner periphery)
- C1: first gap
- C2: second gap
- C3: third gap
- D1: first direction
- D2: second direction
- L: central axis
- P1: first flow path
- P2: second flow path
- P3: flow restriction space
- PH: horizontal flow path
- W: wafer

## Claims

1. A wafer container comprising:
a container body formed by a plurality of wafer supports stacked in a vertical direction and configured to store a wafer;
a top plate provided on an upper side of the container body; and
a bottom plate provided on a lower side of the container body and having an inflow hole for inert gas, wherein
the wafer supports each comprise:
an outer frame forming a side surface of the container body;
a support part protruding inward from the outer frame and configured to support the wafer;
a first guide member and a second guide member provided inside the outer frame and disposed facing each other in a first direction orthogonal to the vertical direction; and
a pair of third guide members provided inside the outer frame and disposed facing each other in a second direction orthogonal to both the vertical direction and the first direction,
the container body includes:
a first flow path formed by the first guide member and configured to guide the inert gas from the inflow hole upward;
a horizontal flow path configured to guide the inert gas from the first flow path in a horizontal direction; and
a second flow path formed by the second guide member and configured to guide the inert gas from the horizontal flow path downward, and
the pair of third guide members prevents the inert gas in the horizontal flow path from deviating in the second direction in the container body.

2. The wafer container according to claim 1, wherein, in two of the wafer supports stacked in the vertical direction, a first gap is formed between the lower first guide member and the upper first guide member, and a second gap is formed between the lower second guide member and the upper second guide member.

3. The wafer container according to claim 2, wherein
in two of the wafer supports stacked in the vertical direction, a third gap is formed between the lower third guide member and the upper third guide member, and
the third gap is smaller than the first gap and smaller than the second gap.

4. The wafer container according to any one of claims 1 to 3, wherein the pair of third guide members includes a pair of inner peripheries extending along an outer periphery of the wafer supported by the support part when viewed from above.

5. The wafer container according to any one of claims 1 to 3, wherein
the pair of third guide members includes a pair of inner peripheries extending along an outer periphery of the wafer supported by the support part when viewed from above, and
in the container body including the wafer supports stacked one another, an assembly of the pairs of inner peripheries forms a restriction wall configured to prevent the inert gas in the horizontal flow path from deviating in the second direction.

6. A wafer support configured to support a wafer, the wafer support comprising:
an outer frame formed in a size to surround the wafer;
a plurality of support parts protruding inward from the outer frame and configured to support the wafer;
a first guide member and a second guide member provided inside the outer frame and disposed facing each other in a first direction orthogonal to a vertical direction; and
a pair of third guide members provided inside the outer frame and disposed facing each other in a second direction orthogonal to both the vertical direction and the first direction, wherein
when the wafer support is stacked, a first flow path is formed by a first frame member of the outer frame and the first guide member, and a second flow path is formed by a second frame member of the outer frame and the second guide member, and
the support parts are disposed between the first guide member and the pair of third guide members, and between the second guide member and the pair of third guide members.

7. The wafer support according to claim 6, wherein the first guide member, the second guide member, and the pair of third guide members are formed in a circular shape surrounding an outer periphery of the wafer supported by the support parts when viewed from above.
